# EUROPEAN PATENT APPLICATION

(11) **EP 4 407 652 A1**
(43) Date of publication of application: **31.07.2024**
(21) Application number: 22872688.1
(22) Date of filing: 05.09.2022
(51) Int. Cl.: H01J 37/06, H01J 37/20, H01J 37/22, H01J 37/244, H01J 37/28, G01N 23/04

(54) **FIVE-DIMENSIONAL ELECTRON MICROSCOPE AND ANALYSIS METHOD THEREFOR**

(30) Priority: 21.09.2021 JP 2021152759
(71) Applicant: RIKEN, Wako-shi, Saitama 351-0198 (JP)
(72) Inventor: SHIMOJIMA, Takahiro, Wako-shi, Saitama 351-0198 (JP); NAKAMURA, Asuka, Wako-shi, Saitama 351-0198 (JP)
(74) Representative: MERH-IP Matias Erny Reichl Hoffmann Patentanwälte PartG mbB
(86) International application number: PCT/JP2022/033313
(87) International publication number: WO 2023/047932

(57) **Abstract**

Since it takes time of seconds to minutes to obtain a single image, time-division observation of a sample cannot be performed for events on a time scale less than the time it takes to obtain the single image of the sample. A five-dimensional electron microscope includes: a photocathode 9 that is irradiated with first laser pulses and generates electron pulses; a sample 15 that is irradiated with the electron pulses and second laser pulses, and becomes excited; a pixel camera 18 that detects the electron pulses that have passed through the sample; and a processing unit that processes an output of the pixel camera, and the electron pulses are delayed by a delay time from the second laser pulses by a delay generator 25.

## Description

### Technical Field

The present invention relates to a five-dimensional electron microscope, and relates specifically to a method for analyzing distortion and magnetization mapping with respect to observation data of the five-dimensional electron microscope.

### Background Art

Since an electron has double properties of wave and particle, the electron can be accelerated to have a wavelength of pico-meter level, and can be made to converge to form an image in a real space. Since the transmission electron microscope (TEM), the scanning transmission electron microscope (STEM), and the aberration correction TEM have made a remarkable advancement, high resolution imaging reaching a sub-angstrom scale is currently enabled. Since electron diffraction analysis, tomography, and single particle imaging have advanced, the electron microscope is currently becoming a central means in many fields from material science to biology. In many electron microscopes, electrons are generated thermally by heating a cathode, or are generated also by field emission. In these electron microscopes, although the temporal resolution reaches millisecond or more although it is restricted by the video rate of the detector, and high spatial resolution can be maintained on the other hand.

PTL 1 relates to a four-dimensional ultrafast electron microscope (UEM) in-situ imaging with ultrafast temporal resolution in TEM, and there is disclosed a technique where single electron imaging is used as a component of the four-dimensional UEM technique and high spatial and temporal resolution are provided.

### Citation List

### Patent Literature

PTL 1: Japanese Unexamined Patent Application Publication (Translation of PCT Application) No. 2012-505521

### Summary of Invention

### Technical Problem

PTL 1 relates to methods and systems for a convergent beam UEM focusing the electron beams onto the sample to measure the structural characteristics in three dimensions as a function of time, discloses that not only four-dimensional imaging of the samples but also characterization of electron energy are provided and that time resolved electron energy loss spectroscopy is performed, however there is no disclosure on the implementation method and the analysis method for the five-dimensional electron microscope.

An object of the present invention is to solve the problem described above and to provide a five-dimensional electron microscope and an analysis method for it.

### Solution to Problem

In order to solve the problem described above, the present invention provides a five-dimensional electron microscope including a photocathode that is irradiated with first laser pulses and generates electron pulses, a sample that is irradiated with the electron pulses and second laser pulses, and becomes excited, a pixel camera that detects electron pulses that have passed through the sample, and a processing unit that processes an output of the pixel camera, and the electron pulses are delayed from the second laser pulses by a predetermined delay time.

Also, in order to solve the problem described above, the present invention provides an analysis method for a five-dimensional electron microscope, the analysis method including steps of irradiating first laser pulses onto a photocathode to generate electron pulses, irradiating second laser pulses and electron pulses to a sample to excite the sample, the electron pulses being delayed from the second laser pulses by a predetermined delay time, detecting the electron pulses that have passed through the sample by a pixel camera, processing an output of the pixel camera, and thereby analyzing the sample.

### Advantageous Effects of Invention

According to the present invention, imaging of five-dimensional information is enabled by using a pixel camera. Brief Description of Drawings

[FIG. 1] FIG. 1 is a schematic drawing of a femtosecond experimental mode related to a first embodiment.
[FIG. 2] FIG. 2 is a schematic drawing of a nanosecond experimental mode related to the first embodiment.
[FIG. 3] FIG. 3 is a schematic drawing of a femtosecond experimental system related to the first embodiment.
[FIG. 4] FIG. 4 is a schematic drawing of a nanosecond experimental system related to the first embodiment.
[FIG. 5] FIG. 5 is a schematic drawing of a differential phase contrast method (DPC-STEM method) and a converged beam electron diffraction method (CBED-STEM method) using a pixel camera related to the first embodiment.
[FIG. 6] FIG. 6 is a schematic drawing of a pump-probe method in transmission electron microscope observation related to the first embodiment.
[FIG. 7] FIG. 7 is a drawing illustrating an observation procedure of a stroboscopic pump-probe method related to the first embodiment.
[FIG. 8] FIG. 8 is a drawing illustrating a five-dimensional data acquisition diagram related to the first embodiment.
[FIG. 9] FIG. 9 is a drawing illustrating a five-dimensional data acquisition method related to the first embodiment.
[FIG. 10] FIG. 10 is a flow chart illustrating a five-dimensional data acquisition method in 5D-STEM related to the first embodiment.
[FIG. 11] FIG. 11 is a drawing illustrating a data example 1 acquired by 5D-STEM related to the first embodiment.
[FIG. 12] FIG. 12 is a drawing illustrating a data example 2 acquired by 5D-STEM related to the first embodiment.
[FIG. 13] FIG. 13 is a drawing illustrating a diaphragm in relation with a data acquisition method related to the first embodiment.
[FIG. 14] FIG. 14 is a drawing illustrating an example of the measurement data obtained from 5D-STEM related to the first embodiment.
[FIG. 15] FIG. 15 is a drawing illustrating an example of an analysis algorithm with respect to 5D-STEM related to the first embodiment.
[FIG. 16] FIG. 16 is a drawing illustrating an example of physical quantity calculation related to the first embodiment.
[FIG. 17] FIG. 17 is a drawing illustrating an example of the change of data by presence and absence of pre-processing related to the first embodiment.
[FIG. 18] FIG. 18 is a drawing illustrating an example of data expressing spatial resolution and temporal resolution related to the first embodiment.

### Description of Embodiments

Embodiments of the present invention will be hereinafter explained consecutively according to the drawings.

### First Embodiment

The present embodiment is an embodiment of a 5D-STEM system capable of obtaining images ultrafast temporally resolved, uses a pixel camera (ultra high performance imaging device) capable of imaging a fast moving image as a camera of the electron microscope, includes a laser optical system, a transmission electron microscope, a pixel camera, and software integrating them, and enables imaging of five-dimensional information. Here, "fast" is defined corresponding to an oscillating frequency of a scan coil.

That is to say, the present invention is an embodiment of a five-dimensional electron microscope and an observation method of it, the five-dimensional electron microscope including a photocathode that is irradiated with first laser pulses and generates electron pulses, a sample that is irradiated with electron pulses and second laser pulses, and becomes excited, a pixel camera that detects electron pulses that have passed through the sample, and a processing unit that processes an output of the pixel camera, the electron pulses being delayed from the second laser pulses by a predetermined delay time.

The transmission electron microscope includes a scan coil enabling electron beam scanning, and includes a window and a mirror guiding laser pulses to a photocathode and a sample. By selecting a femtosecond laser or a nanosecond laser, it is possible to perform temporal resolution measurement in a wide temporal scale from a femtosecond to a nanosecond. Normally, repetition frequency of the pulse laser is set between 1 kHz to 1 MHz. In general, there is used a laser light of a near-infrared region or a laser light whose wavelength is converted using a non-linear optical element. It is required that the pixel camera can load two-dimensional data within the time of approximately a millisecond. Also, the pixel camera is required to be a camera employing a direct detection method in order to measure a minute electron pulse with high sensitivity.

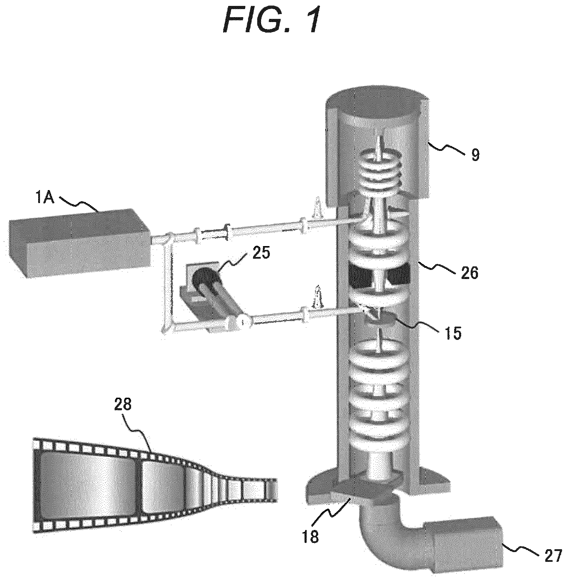

FIG. 1 is a schematic drawing of a five-dimensional electron microscope in a femtosecond experimental mode related to the first embodiment. In the femtosecond experimental mode, a femtosecond laser 1A is divided into two beams, and is introduced to an electron microscope (STEM) 26 including a scan coil. One is used for electron pulse generation, the other is used for sample excitation, and the delay time between two pulses is mechanically controlled by a delay generator 25. In order to generate electron pulses, there is used a laser light having energy higher than that of a work function of a photocathode (LaB6 and metal) 9. It is capable of obtaining ultrafast moving image of nano-material 28 by the pixel camera 18. Also, an output of the pixel camera 18 is converted to the ultrafast moving image 28 by predetermined image processing by a processing unit including a central processing unit (CPU) and the like. An electron energy loss spectroscopic detector 27 is used for analyzing the element composition and the chemical bonding state of a sample 15. The processing unit performs not only image processing but also control of operation of the electron microscope 26 such as scanning of electron pulses.

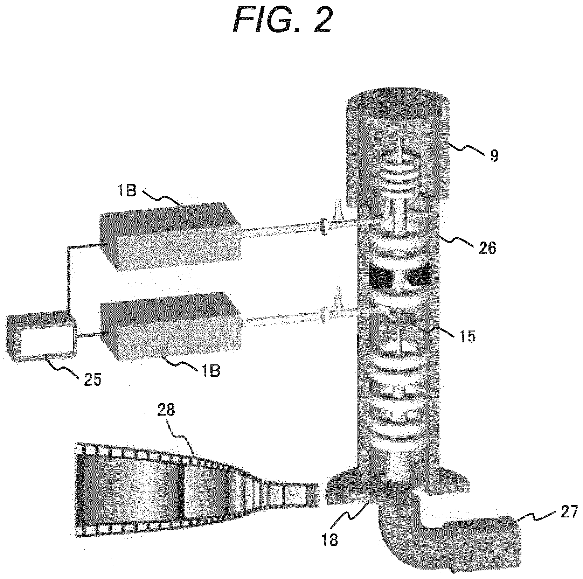

FIG. 2 is a schematic drawing of a five-dimensional electron microscope in a nanosecond experimental mode related to the first embodiment. In the nanosecond experimental mode, laser pulses generated from two sets of nanosecond lasers 1B are used for electron pulse generation and sample excitation respectively, and the delay time between two pulses is electrically controlled by the delay generator 25.

In both experimental modes illustrated in FIG. 1 and FIG. 2, STEM observation is performed using converged electron pulses of the electron microscope 26, and temporal resolution observation based on the stroboscopic pump-probe principle is performed by controlling the delay time with respect to the laser pulses.

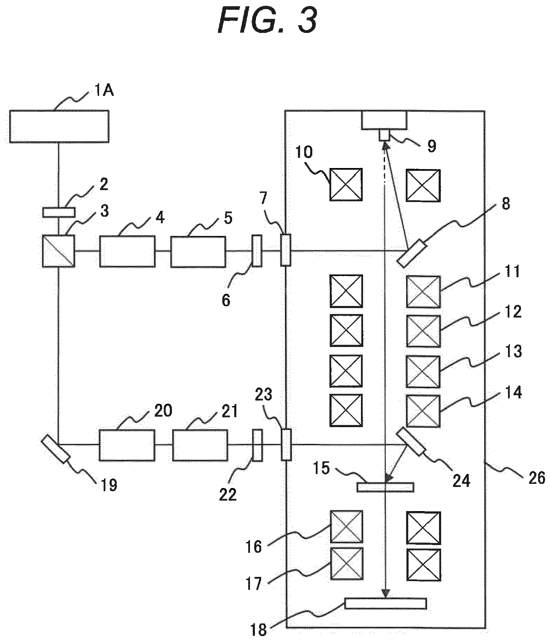

FIG. 3 illustrates concrete configuration elements of a five-dimensional electron microscope system in a femtosecond experimental mode related to the present embodiment. A laser light from the femtosecond laser 1A passes through a 1/2 wavelength plate 2, is divided by a cube beam splitter 3, each enters windows 7, 23 of the electron microscope 26 through wavelength conversion devices 4, 20, beam expanders 5,21, and lenses 6, 22 respectively, and performs electron pulse generation and sample excitation. Electrons generated by the photocathode 9 by irradiation of the laser light reflected by a mirror 8 is accelerated by an accelerator 10, and is thereafter irradiated onto the sample 15 through an optical system including a condenser lens 11, a condenser mini-lens 12, a deflection coil 13 that is a deflection unit for scanning electron pulses, and an object lens 14.

On the other hand, electrons having passed through the sample 15 excited by the laser light reflected by a mirror 24 go through an object lens 16 and an imaging system lens 17, and are imaged by the pixel camera 18.

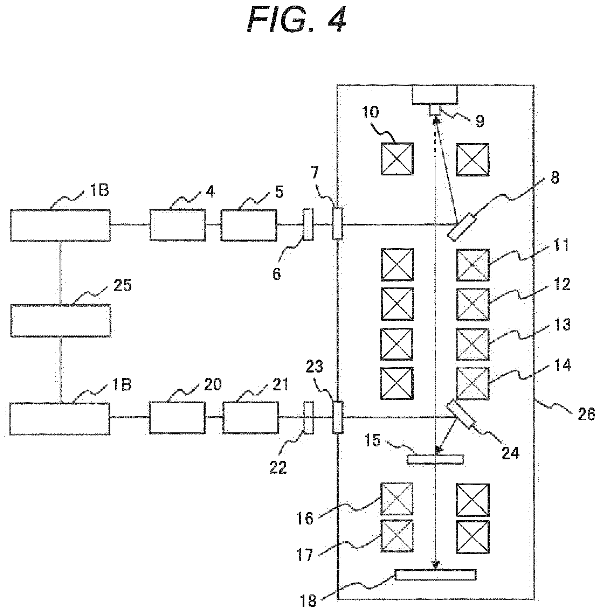

FIG. 4 illustrates concrete configuration elements of a five-dimensional electron microscope system in a nanosecond experimental mode related to the present embodiment. As explained in FIG. 2, laser pulses generated from two sets of the nanosecond lasers 1B are used for electron pulse generation and sample excitation respectively, and the delay time between two pulses is electrically controlled by the delay generator 25. The configuration of the electron microscope 26 is same to that illustrated in FIG. 3.

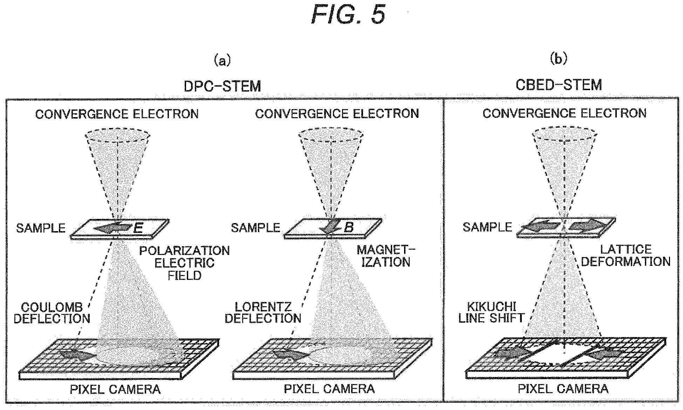

An analysis method of the five-dimensional electron microscope of the present embodiment is illustrated schematically in FIG. 5. In general, in STEM observation, it is possible to perform a differential phase contrast method (DPC-STEM method) and a converged beam electron diffraction method (CBED-STEM method) by using a pixel camera. A polarization electric field and a magnetization vector in a sample are acquired by the former method, and quantitative spatial distribution related to a crystal lattice is acquired by the latter method.

According to the present embodiment, there are employed a DPC-STEM method called a four-dimensional STEM illustrated in FIG. 5 (a) and using a pixel camera, and a CBED-STEM method illustrated in FIG. 5 (b). According to these methods, in addition to the sample shape, various physical quantity such as the magnetization vector, electric field polarization, lattice constant, distortion, and inclination angle can be acquired quantitatively. The data obtained by combination of these methods and the stroboscopic pump-probe method are five-dimensional data combining two dimension of the sample surface, two dimension of the reciprocal lattice space, and one dimension of the time.

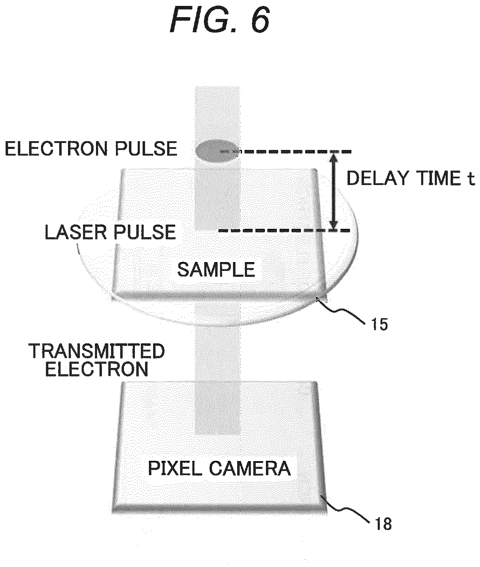

FIG. 6 illustrates a schematic drawing of a pump-probe method in electron microscope observation method of the present embodiment. Electron pulses and laser pulses are irradiated generally coaxially to the sample 15 of a thin piece through which the electron beam of the electron microscope can pass through. Response of the sample 15 excited by the laser pulses is observed by the electron pulses irradiated to be delayed by the delay time t. The electron pulses having passed through the sample 15 is detected as two-dimensional image data by the pixel camera 18 located behind the sample 15. Among the pump-probe methods, a method specialized in observing a reversible response to a stimulus is the stroboscopic pump-probe method.

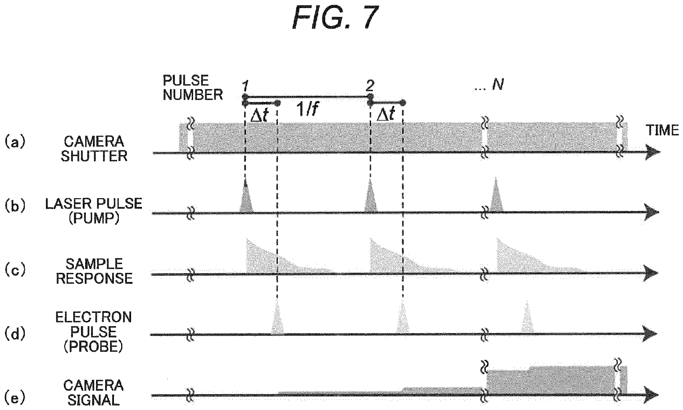

FIG. 7 illustrates an observation procedure of the stroboscopic pump-probe method. The waveforms of (a) to (e) of FIG. 7 illustrate the camera shutter, laser pulse, sample response, electron pulse, and camera signal respectively. As illustrated in FIG. 7 (a), firstly, the shutter of the camera of the transmission electron microscope is opened, and exposure is started. Secondly, as illustrated in FIG. 7 (b), laser pulses are repeatedly irradiated onto the sample 15 to impart stimuli.

Here, as illustrated in FIG. 7 (c), the sample repeats same responses every time against the stimuli, and is required to be entirely relaxed until the time when next laser pulse is irradiated (an inverse number of the repetition frequency f). Thirdly, at timing when the delay time t elapses after irradiation of the laser pulse, the electron pulse is irradiated to the sample, and electrons having passed through the sample 15 are detected by the camera 18.

Normally, since the electron pulse illustrated in FIG. 7 (d) is configured of less number of piece of electrons of one to 1,000 approximately, in order to obtain an image with sufficient contrast, many cumulating number of times are necessary. Here, utilizing periodicity of the laser, phenomena are repeated to cumulate the camera signals, and the shutter is closed when sufficient signals are obtained as illustrated in FIG. 7 (e).

The causes limiting the overall temporal resolution within this series of processes are three points of the time width of the laser pulse, the time width of the electron pulse, and accuracy of the delay time. In fact, the overall temporal resolution is often determined by the time width of the electron pulse. Although imaging of a moving image by a high-speed camera of a prior art had a problem that the temporal resolution was limited to approximately a millisecond by the shutter speed of a camera, according to the stroboscopic pump-probe method of the present embodiment, since the temporal resolution does not depend on the shutter speed of a camera but depends on pulse property of the laser and electron, imaging of an ultrafast moving image is enabled.

That is to say, according to 5D-STEM of the present embodiment, the stroboscopic pump-probe method is applied to DPC-STEM method and CBED-STEM method by a scanning transmission electron microscope including a pulse laser system and a pixel camera, five-dimensional data including two-dimensional space (x, y), two-dimensional wave number space (kₓ, k_{y}), and time (t) are acquired fast, and an ultrafast moving image of nano-material is formed by a post process after acquisition of the data.

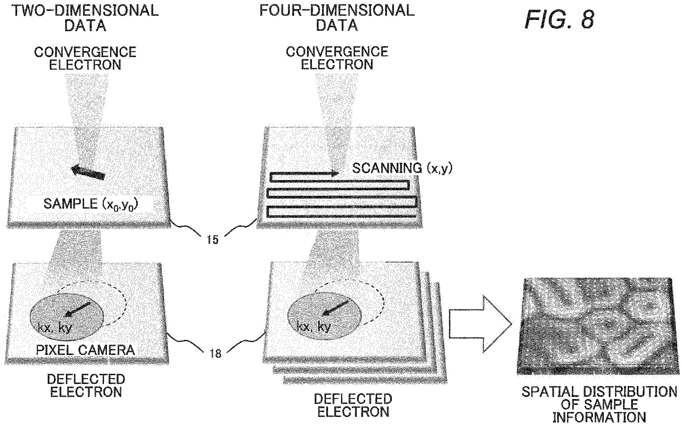

As illustrated in the left of FIG. 8, according to a general DPC-STEM method using a pixel camera, when a convergence electron is irradiated in a predetermined coordinate (x0, y0) on the sample, an electron deflected by magnetization or electric polarization is detected on the pixel camera as a two-dimensional image (wave number kₓ, k_{y}). As illustrated in the center of FIG. 8, by repeating similar observations while the convergence electron pulses are scanned on the sample, the wave number information (kₓ, k_{y}) of the deflected electron is acquired in a general coordinate (x, y), and four-dimensional data are obtained. Also, as illustrated in the right of FIG. 8, it is possible to convert the wave number information (kₓ, k_{y}) having been obtained to a deflection angle θ and a deflection amount r of the electron, and to draw a spatial distribution of the sample information including magnetization m(r,) or electric polarization E(r,).

Next, a five-dimensional data acquisition method in 5D-STEM will be explained. According to 5D-STEM of the present embodiment, by using electron pulses, the stroboscopic pump-probe method is applied to DPC-STEM method described above, and five-dimensional data where the time axis is added to four-dimensional data are acquired.

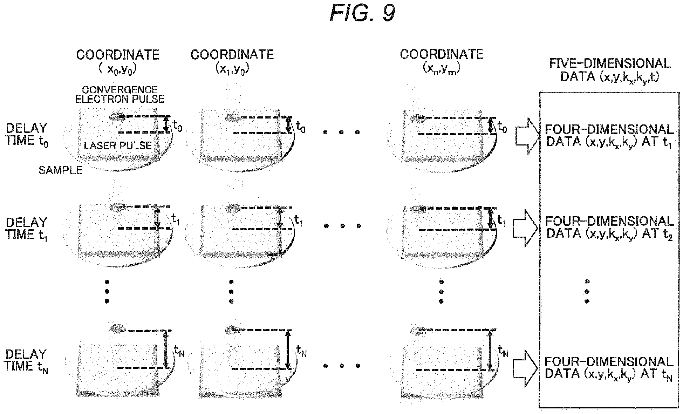

In concrete terms, the five-dimensional data are acquired by such procedure as illustrated in FIG. 9. A pulse laser irradiated to entire sample in advance causes an excited state of the sample, convergence electron pulses are irradiated here to be delayed by delay time t0, and thereby the wave number distribution of the deflected electron in the sample coordinate (x0, y0) is acquired as two-dimensional image data. Electron pulses are scanned in a state of fixing the delay time t0, and similar observation is performed in an adjacent coordinate (x1, y0). When scanning to a coordinate (xₙ, yₘ) is completed, four-dimensional data (x, y, kₓ, k_{y}) equivalent to a snap shot of a phenomenon at the delay time t0 are obtained.

Consecutively, acquisition of the four-dimensional data by similar measurement is repeated while the delay time is slightly changed (t0, t1, ..., tN) by an optical delay stage and a delay generator. As a result, five-dimensional data (x, y, kₓ, k_{y}, t) where a time axis is added to the four-dimensional data (x, y, kₓ, k_{y}) illustrated in the right of FIG. 9 are obtained. Thus, it is enabled to form a moving image having temporal accuracy of a degree of the time width of the electron pulse (100 femtosecond or 1 nanosecond for example). Similar measurement principle can be applied also to the CBED-STEM method.

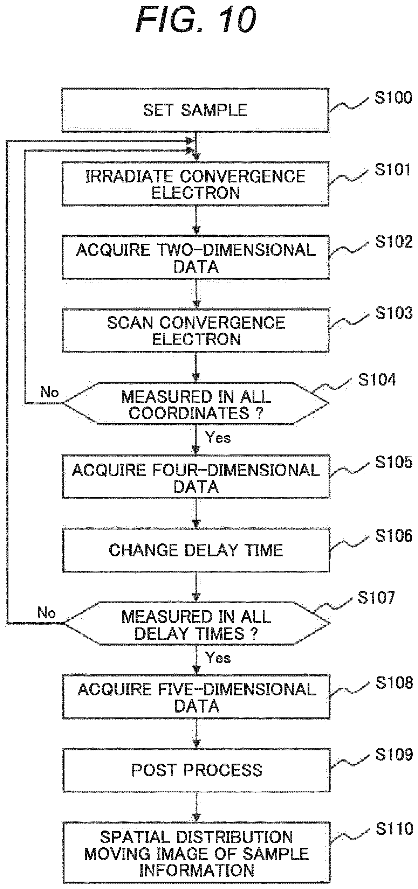

In concrete terms, as illustrated in FIG. 10 namely the diagram on the data acquisition method related to FIG. 8 and FIG. 9, the pulse laser irradiated to the entire sample in advance causes an excited state of the sample, convergence electron pulses are irradiated here to be delayed by the delay time t0 (S101), and thereby the wave number distribution of the deflected electron in the sample coordinate (x0, y0) is acquired as two-dimensional image data (S102). Electron pulses are scanned in a state of fixing the delay time t0 (S103), and similar observation is performed in an adjacent coordinate (x1, y0). When scanning to a coordinate (xₙ, yₘ) is completed (S104), four-dimensional data (x, y, kₓ, k_{y}) equivalent to a snap shot of a phenomenon at the delay time t0 are obtained (S105).

Consecutively, while the delay time is slightly changed by an optical delay stage and a delay generator (t0, t1, ..., tN) (S106), acquisition of the four-dimensional data by similar measurement is repeated (S107). As a result, five-dimensional data (x, y, kₓ, k_{y}, t) where a time axis is added to the four-dimensional data (x, y, kₓ, k_{y}) are obtained (S108). Thus, it is enabled to form a moving image having temporal accuracy of a degree of the time width of the electron pulse (100 femtosecond or 1 nanosecond for example) (S109, S110). Similar measurement principle can be applied also to the CBED-STEM method.

As a concrete experiment condition, for example, when the dwell time of the electron beam in each coordinate is set to 1 millisecond and 256×256 pieces of coordinates are to be scanned, time required for acquisition of a single sheet of image is approximately 1 minute as described above. When repetition frequency of the laser pulses and the electron pulses is set to 100 kHz, two-dimensional image data where 100 shots of electron pulses are cumulated in each coordinate are obtained. Since approximately 1 to 1,000 pieces of electrons are included in an individual electron pulse, a single two-dimensional image includes approximately 100 to 100,000 pieces of electrons. When the image is not clear due to shortage of the number of pieces of electron, by repeating the experiment of a same measurement condition and integrating the data, the image quality can be improved.

As explained above, by 5D-STEM of the present embodiment, information on the electric field, magnetic field, and crystal lattice in a solid substance changing fast according to the external field can be obtained quantitatively. For example, it is supposed to be capable of observing processes through which a magnetic wall in ferromagnetic material known as a magnetic structural body of a nano scale, a vortex in a superconductor, magnetic skyrmions in a chiral magnetic body, and so on are generated, discreated, deformed, and transported by stimuli. Also, fast response by light is expected also in a ferroelectric domain in a ferroelectric substance bringing electric field distribution in a solid substance and a p-n junction interface in a semiconductor. Further, it is possible to track a process through which various phenomena such as mechanical deformation, acoustic phonon, and structural phase transition seen in a wider substance group are propagated in a space with high temporal resolution. With respect to a stimulus to a sample, not only laser pulses described above but also pulses of the electric current, magnetic field, pressure, and the like also can be utilized, and stimulus can be selected according to the phenomenon to be observed.

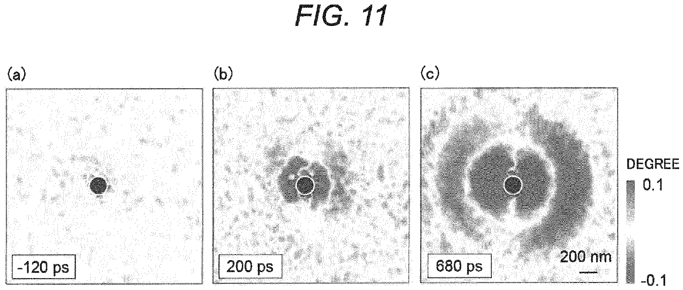

FIG. 11 illustrates a data example acquired by 5D-STEM of the present embodiment. A state of acoustic phonon propagation in a Si thin piece after irradiating the femtosecond laser observed by CBED-STEM method is illustrated. Such state is known that deformation of the thin piece sample propagates radially with a wave source of a structure of metal tungsten vapor-deposited by a focused ion beam method. The contrast of the image expresses distortion of the thin piece sample extracted quantitatively from an electron diffraction figure.

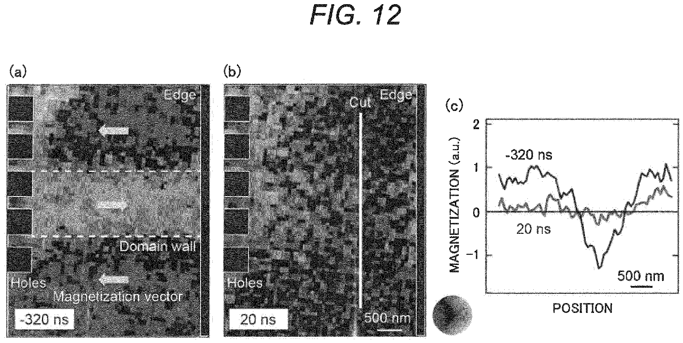

FIG. 12 illustrates another data example acquired by 5D-STEM of the present embodiment. There is illustrated a discreating and reforming process of a magnetic wall in a FeNiPdP alloy after irradiating a nanosecond laser observed by the DPC-STEM method. It is known that two pieces of the magnetic wall (white dotted line) pinned to a rectangular hole formed by a focused ion beam method form a magnetic domain structure where the direction of the magnetization vector (white arrow) differs by 180 degrees (FIG. 12 (a)). Here, the color and intensity of the image express the direction and the absolute value of the magnetization vector. Since the magnetic phase transition occurs by temperature rise of the sample caused by irradiation of the nanosecond laser, such state is known that the magnetization vector almost disappears as illustrated in FIG. 12 (b). From the intensity profile on the white line of FIG. 12 (b), it is known that the magnetic wall almost disappears within 20 nanoseconds after irradiation of light as illustrated in FIG. 12 (c).

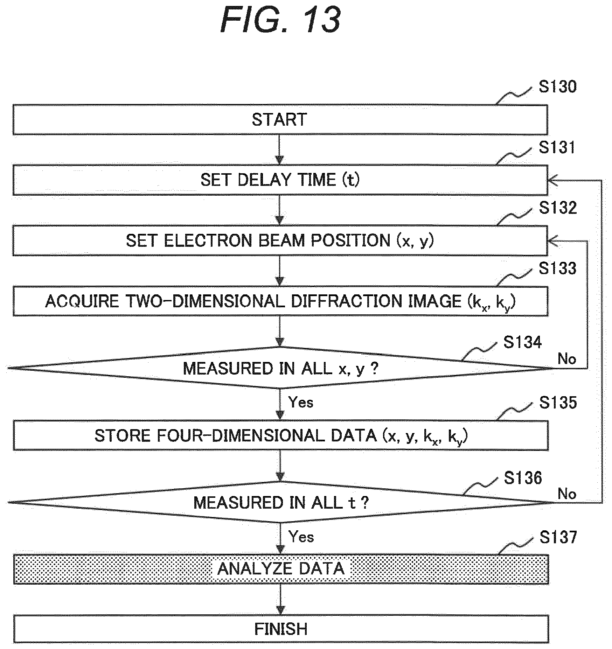

FIG. 13 illustrates a summary of the total process of 5D-STEM of the present embodiment. A diffraction image (kₓ, k_{y}) within a target range of the space (x, y) and time (t) is acquired using an optical delay stage and a deflection coil within the electron microscope. Data obtained become five-dimensional data having five axes of (x, y, kₓ, k_{y}, t). The present embodiment provides a data analysis method for the five-dimensional data. By calculating a physical quantity from the data of the diffraction image (kₓ, k_{y}) out of the five-dimensional data having the axes of (x, y, kₓ, k_{y}, t), space (x, y) and time(t)-dependent three-dimensional data of the physical quantity are formed.

As illustrated in FIG. 13, when the delay time (t) is set (S131) and the electron beam position (x, y) is set (S132) by starting of the process (S130), a two-dimensional diffraction image (kₓ, k_{y}) is acquired, and measurement at all x, y finishes ("Yes" in S134), four-dimensional data (x, y, kₓ, k_{y}) are stored (S135). When measurement finishes at all t ("Yes" in S136), data analysis is performed (S137) and the process is finished.

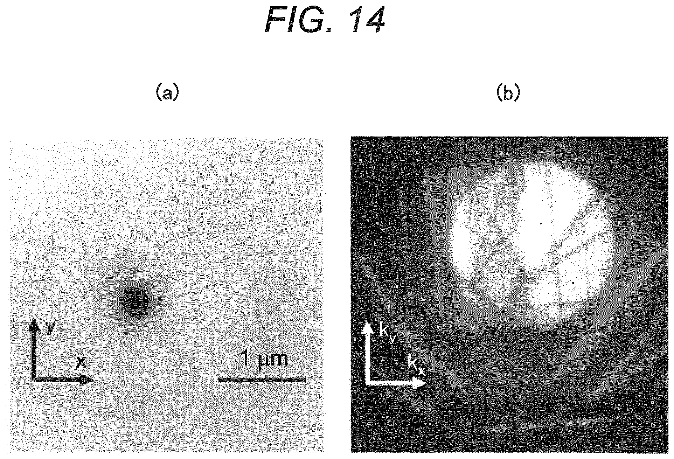

FIG. 14 illustrates representative measurement data obtained from 5D-STEM of the present embodiment. t is equal to -40 ps. FIG. 14 (a) is a real image of a silicon sample obtained by the analysis, and a black circle at the center is a tungsten vapor-deposited region. FIG. 14 (b) is a convergence electron diffraction figure, the position of the line corresponds to the distortion within the sample and the position of the transmission electron (the center of the circle) corresponds to the magnitude of magnetization respectively. In fact, four-dimensional data recording the convergence electron diffraction figure such as FIG. 14 (b) are obtained for each point of the space of FIG. 14 (a) with respect to each clock time.

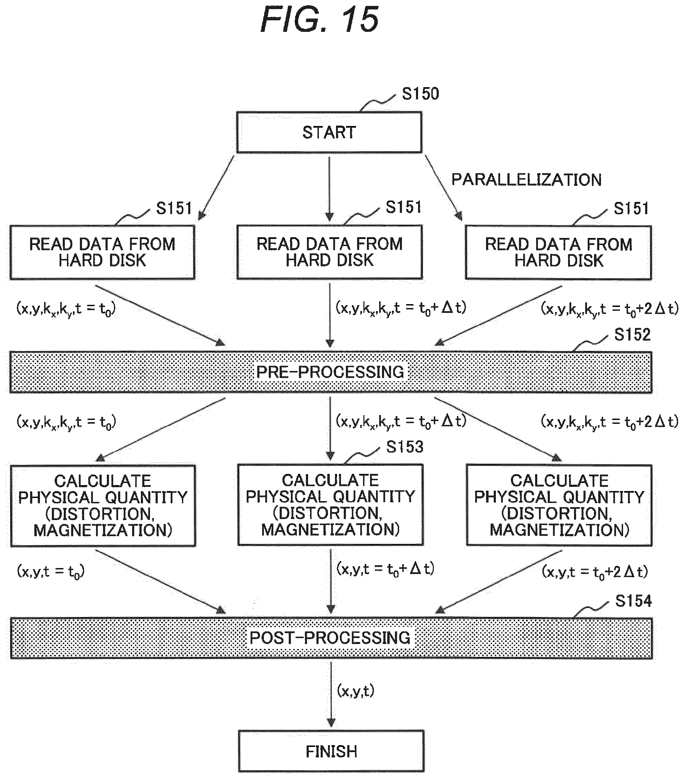

FIG. 15 illustrates an analysis algorithm with respect to 5D-STEM of the present embodiment. As described above, since the intensity of the electron beam used in 5D-STEM is very low, analysis cannot be performed well by the method described above where an analysis method used in 4D-STEM is simply parallelized.

Therefore, according to the present embodiment, after data reading and physical quantity calculation, pre-processing (S152) and post-processing (S154) are performed respectively. In concrete terms, in the pre-processing (S152), four-dimensional data having been read in parallel are combined once and are made five-dimensional data. By performing smoothing of the five-dimensional data along each axis of x, y, kₓ, k_{y}, t, the signal-to-noise ratio of the data is improved with the temporal and spatial resolution being slightly sacrificed. Also, in s similar manner, in the post-processing (S154) also, two-dimensional data after the physical quantity calculation are combined and are made three-dimensional data, and smoothing along each axis of x, y, t is thereafter performed. These pre-processing and post-processing are algorithms newly added in an analysis algorithm of the present embodiment.

As a result of using laser-derived electron pulses for exciting the sample as described above, compared to a case of using electron pulses using an electron beam of a prior art, the noise on information obtained per one time of irradiation comes to increase. In order to cope with it, according to the present embodiment, a problem of the noise was solved by daringly performing processes described below in pre-processing (smoothing of five-dimensional information) and post-processing (smoothing of three-dimensional information) before and after physical quantity calculation in spite that there was a demerit of increase of the calculation volume.

When algorithm of repeating 4D-STEM analysis of a prior art without smoothing is employed, in order to reduce noises, it takes the measurement time of 10 time or more typically. This means that the cumulating time of one month or more is required in a case of the embodiment related to CBED-STEM of FIG. 10 or FIG. 13 for example (approximately three days of the total cumulating time).

In physical quantity calculation, two types of calculation method of distortion calculation and magnetization calculation are used. In distortion calculation, the scattering angle of electrons scattered by the sample is obtained by detecting the local maximum value of the intensity profile along a certain straight line within a diffraction image. Since this scattering angle changes according to the distortion of the sample, the magnitude of the distortion at an optional position within the sample can be calculated. Also, when magnetization within the sample is to be obtained by magnetization calculation, the convergence electron beam diffraction figure is binarized by a proper threshold value, and the gravity center position of the binarized image is obtained.

Since this gravity center position is equivalent to the deflection amount of an electron beam, the gravity center position is proportional to magnetization of the sample. When the deflection amount is to be obtained, a deflection amount of the electron beam when there is not a sample is deducted as the background. The deflection amount in kₓ and k_{y} direction is stored as a complex number, and eventually becomes complex number data having axes of (x, y, t) .

According to the present embodiment, it is enabled to calculate a meaningful physical quantity from data with a large noise measured by an electron beam of very low intensity by pre/post processing that totally takes information in the time, space, and wave number space in consideration as described above.

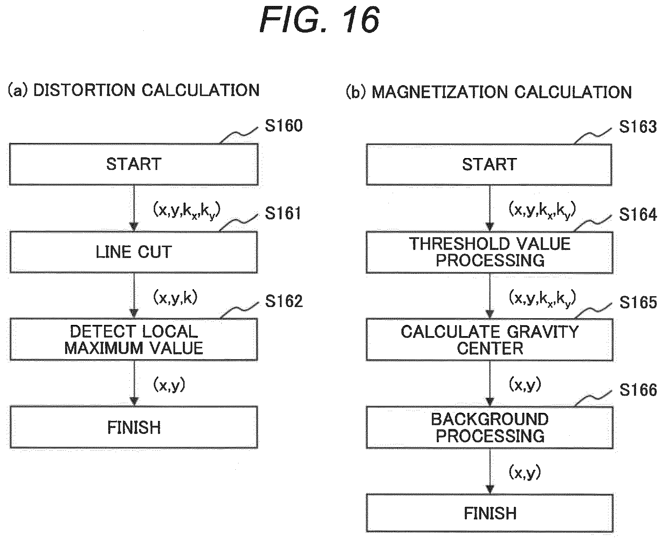

FIG. 16 illustrates an example of physical quantity calculation. FIG. 16 (a) represents distortion calculation, and FIG. 16 (b) represents magnetization calculation. Upon starting (S160, S163), line cut (S161) and local maximum value detection (S162) as well as threshold value processing (S164), gravity center calculation (S165), and background processing (S166) are performed respectively, and the process is finished.

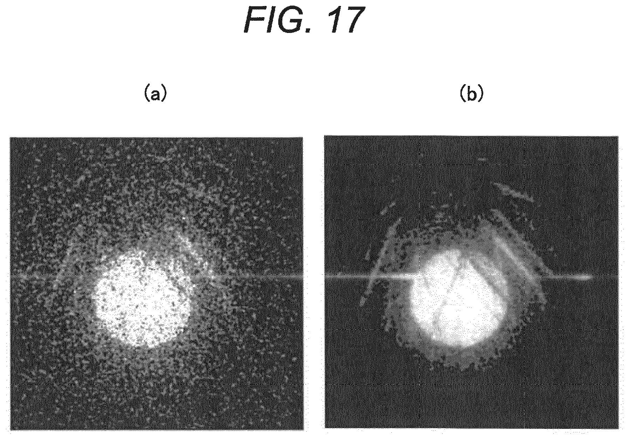

FIG. 17 illustrates an example of the change of data by presence and absence of pre-processing. Compared to the diffraction image of a case without pre-processing illustrated in FIG. 17 (a), in the data where the averaging filter of size 3 is applied to all directions of the space, wave number space, and time illustrated in FIG. 17 (b), it is known that the signal-to-noise ratio is dramatically improved and analysis is facilitated.

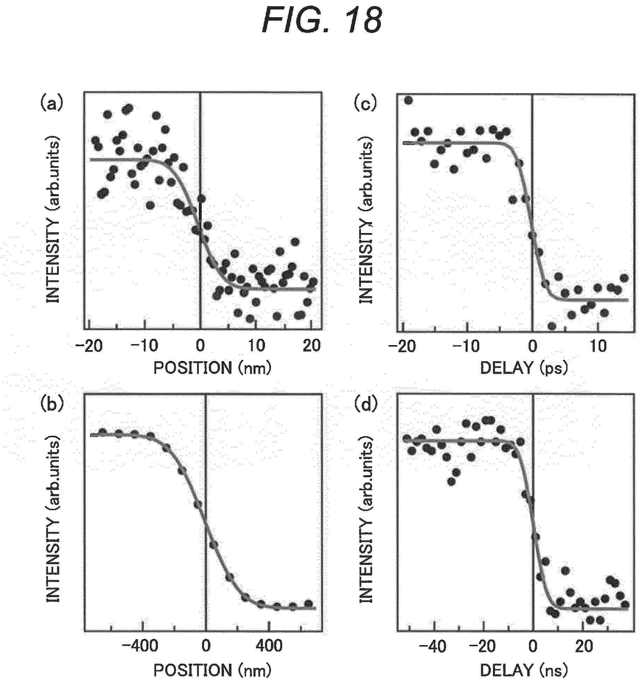

FIG. 18 illustrates an example of data expressing spatial resolution and temporal resolution related to the present embodiment. FIG. 18 (a) and (b) illustrate spatial resolution evaluation data observed under 2 Tesla magnetic field and under zero magnetic field. FIG. 18 (a) and (b) were obtained by spatial mapping of GaP/Si interface and YIG thin piece sample end by CBED. The curved line in the drawing expresses a step function convoluted with a Gaussian function in order to evaluate broadening by spatial resolution. 8 nanometer spatial resolution was obtained in FIG. 18 (a), and 400 nanometer spatial resolution was obtained in FIG. 18 (b).

FIG. 18 (c) and (d) illustrate temporal resolution evaluation data of the cases of using a femtosecond laser and a nanosecond laser under 2 Tesla magnetic field. The curved line in the drawing expresses a step function convoluted with a Gaussian function in order to evaluate broadening by temporal resolution. 4 picosecond temporal resolution was obtained in FIG. 18 (c), and 10 nanosecond temporal resolution was obtained in FIG. 18 (d).

According to the present embodiment, by applying a stroboscopic pump-probe method to DPC-STEM method and CBED-STEM method using a pixel camera, the temporal resolution in both methods can be improved by 12 digits or more.

The present invention is not to be limited to the embodiments described above, and various modifications are to be included. For example, the embodiments described above were explained in detail for better understanding of the present invention, and are not necessarily to be limited to those including all configurations having been explained.

### Reference Signs List

- 1A:: femtosecond laser
- 1B:: nanosecond laser
- 2:: 1/2 wavelength plate
- 3:: cube beam splitter
- 4:: wavelength conversion device
- 5:: beam expander
- 6:: lens
- 7:: window
- 8:: mirror
- 9:: photocathode
- 10:: accelerator
- 11:: condenser lens
- 12:: condenser mini-lens
- 13:: deflection coil
- 14:: object lens
- 15:: sample
- 16:: object lens
- 17:: imaging system lens
- 18:: pixel camera
- 19:: mirror
- 20:: wavelength conversion device
- 21:: beam expander
- 22:: lens
- 23:: window
- 24:: mirror
- 25:: delay generator
- 26:: electron microscope (STEM)
- 28:: ultrafast moving image of nano-material
- 27:: electric energy loss spectroscopic detector

## Claims

1. A five-dimensional electron microscope comprising:
a photocathode that is irradiated with first laser pulses and generates electron pulses;
a sample that is irradiated with the electron pulses and second laser pulses, and becomes excited;
a pixel camera that detects electron pulses that have passed through the sample; and
a processing unit that processes an output of the pixel camera, wherein
the electron pulses are delayed from the second laser pulses by a predetermined delay time.

2. The five-dimensional electron microscope according to claim 1 further comprising,
a delay generator that controls delay time between the first laser pulses and the second laser pulses.

3. The five-dimensional electron microscope according to claim 2 further comprising,
a deflection unit that scans the electron pulses.

4. The five-dimensional electron microscope according to claim 3, wherein
the electron pulses are detected by the pixel camera as two-dimensional image data.

5. The five-dimensional electron microscope according to claim 4, wherein
the two-dimensional image data are a two-dimensional diffraction image.

6. The five-dimensional electron microscope according to claim 5, wherein
the processing unit performs control to acquire four-dimensional data by scanning the electron pulses, the four-dimensional data being based on the two-dimensional diffraction image, to changes the delay time to perform measurement at a plurality of delay times, and to acquire five-dimensional data.

7. An analysis method for a five-dimensional electron microscope, the analysis method comprising steps of:
irradiating first laser pulses onto a photocathode to generate electron pulses;
irradiating second laser pulses and electron pulses to a sample to excite the sample, the electron pulses being delayed from the second laser pulses by a predetermined delay time;
detecting the electron pulses that have passed through the sample by a pixel camera;
processing an output of the pixel camera, and
thereby analyzing the sample.

8. The analysis method according to claim 7, wherein
the electron pulses are detected by the pixel camera as two-dimensional image data.

9. The analysis method according to claim 8, wherein
the two-dimensional image data are a two-dimensional diffraction image.

10. The analysis method according to claim 9 further comprising a step of:
performing control to acquire four-dimensional data by scanning the electron pulses, the four-dimensional data being based on the two-dimensional diffraction image, to change the delay time to perform measurement at a plurality of delay times, and to acquire five-dimensional data.

11. The analysis method according to claim 10, wherein
the four-dimensional data is a sample shape, magnetization vector, electric field polarization, lattice constant, distortion, or inclination angle.
